# EUROPEAN PATENT SPECIFICATION

(11) **EP 3 173 230 B1**
(45) Date of publication and mention of the grant of the patent: **20.01.2021**
(21) Application number: 15824728.8
(22) Date of filing: 24.07.2015
(51) Int. Cl.: B32B 27/30, B32B 27/40, C08G 18/62, H01L 33/00, H01L 51/50, H05B 33/04, B32B 7/10, B32B 7/12, B32B 27/08, B32B 27/16, B32B 27/32, B32B 27/34, B32B 27/36

(54) **MULTILAYER FILM, LAMINATE, WAVELENGTH CONVERSION SHEET, BACKLIGHT UNIT, AND ELECTROLUMINESCENT LIGHT EMITTING UNIT**
MEHRSCHICHTFOLIE, LAMINAT, WELLENLÄNGENUMWANDLUNGSFOLIE, RÜCKBELEUCHTUNGSEINHEIT UND ELEKTROLUMINESZENTE LICHTEMITTIERENDE EINHEIT
FILM MULTICOUCHE, STRATIFIÉ, FEUILLE DE CONVERSION DE LONGUEUR D'ONDE, UNITÉ DE RÉTROÉCLAIRAGE ET UNITÉ D'ÉMISSION DE LUMIÈRE ÉLECTROLUMINESCENTE

(30) Priority: 24.07.2014 JP 2014150811; 25.03.2015 JP 2015062254
(43) Date of publication of application: 31.05.2017
(73) Proprietor: Toppan Printing Co., Ltd., Tokyo 110-0016 (JP)
(72) Inventor: NISHIKAWA, Takeshi, Tokyo 110-0016 (JP); SHODO, Ryo, Tokyo 110-0016 (JP)
(74) Representative: TBK
(86) International application number: PCT/JP2015/071110
(87) International publication number: WO 2016/013656

(56) References cited:
- EP-A1- 3 064 829
- EP-A1- 3 128 350
- EP-A1- 3 171 072
- WO-A1-2010/005030
- WO-A1-2013/005767
- JP-A- 2007 076 207
- JP-A- 2009 070 814
- JP-A- 2009 083 465
- JP-A- 2011 056 908
- JP-A- 2012 097 161
- JP-A- 2013 069 615
- JP-A- 2013 544 018
- US-A1- 2008 185 600
- US-A1- 2011 244 218

## Description

### [Technical Field]

The present invention relates to a laminate film and a laminate, and a wavelength conversion sheet, a backlight unit and an electroluminescent light-emitting unit.

### [Background Art]

In light-emitting units, such as backlight units of liquid crystal displays and electroluminescent light-emitting units, emitters or phosphors may come into contact with oxygen or moisture for a long time and may be impaired in their performance as emitters or phosphors. Therefore, these light-emitting units use a laminate film made up of a polymer film which is provided with a gas barrier layer, with an adhesive being coated thereto to serve as a packaging material or a protective material for the emitters, phosphors.

However, the laminate films mentioned above cannot achieve intimate contact between the layers configuring the laminate film, and thus may have difficulty in achieving sufficient gas barrier properties. In this regard, PTL 1, for example, proposes configuring a laminate having barrier properties, using terminal hydroxyl group-containing (meth)acrylate as a material of an organic layer to thereby improve intimate contact between an adhesive layer that contains an epoxy-based adhesive and the organic layer.

### [Citation List]

### [Patent Literature]

[PTL 1]
JP-A 2011-56908

EP 3 171 072 A1, a document according to Art. 54(3) EPC, describes a protective film for wavelength conversion sheet for protecting a fluorescent substance in a wavelength conversion sheet, the protective film for wavelength conversion sheet having a structure in which two or more barrier films, each comprising a substrate and one or more barrier layers provided on at least one surface of the substrate, are laminated.

EP 3 128 350 A1, a document according to Art. 54(3) EPC, describes a wavelength conversion sheet which includes a phosphor, and one or more barrier films that seal the phosphor. At least one of the barrier films includes a coating layer having an optical function. The coating layer is provided to a surface of the barrier film.

EP 3 064 829 A1, a document according to Art. 54(3) EPC, describes a wavelength conversion sheet, including a lamination of a phosphor layer using quantum dots, and a barrier film, characterized in that the barrier film is obtained by laminating a barrier layer on one surface of a polyethylene terephthalate film having an acid number smaller than 25 inclusive.

WO 2010/005030 A1 describes a solar cell backsheet. The solar cell backsheet has a light-blocking polyolefin resin colored layer and a weather-resistant polyester resin layer, and a gas barrier layer lying between these layers and including a weather-resistant coating layer and an inorganic thin-film layer. The weather-resistant coating layer of the solar cell backsheet comprises at least one material selected from (a) a crosslinked product of polycaprolactone polyol and/or polycarbonate polyol, (b) a crosslinked product of modified polyvinyl alcohol, and (c) an acrylic copolymer having at least one group selected from a UV-stabilizing group, a UV-absorbing group, and a cycloalkyl group.

WO 2013/005767 A1 describes a multilayer film having gas barrier properties, an adhesive, and a coating material, and further relates to a polyester resin composition.

US 2011/244218 A1 describes a coating composition including: (a) inorganic particles having an average particle size of 1 to 100 nm; (b) an ionizing radiation-curing material for forming a binder; (c) a photopolymerization initiator; and (d) an organic solvent. The coating composition preferably includes a monomer having at least two hydroxyl groups per molecule in a mass fraction of 0.1 to 3.0 mass % relative to the total solid content of the composition. WO2004101276 discloses a transparent gas barrier laminated film.

### [Summary of THE Invention]

### [Technical Problem]

According to the studies conducted by the present inventors, however, intimate contact has by no means been sufficiently achieved if the laminate having barrier properties described in PTL 1 is used. The present invention has as its object to provide a laminate film and a laminate that can improve intimate contact and achieve good moisture impermeability, and to provide a wavelength conversion sheet, a backlight unit and an electroluminescent light-emitting unit, obtained using the laminate film and the laminate.

### [Solution to Problem]

The present invention provides a laminate film including a barrier film and an adhesion-enhancing layer formed on the barrier film. In the laminate film; the adhesion-enhancing layer contains a polymer that contains a group having a reactive carbon-carbon double bond and two or more hydroxyl groups, and polyisocyanate; and the adhesion-enhancing layer has a thickness in a range of 0.01 µm or more to 1 µm or less. In the laminate film of the present invention, the above configuration of the adhesion-enhancing layer improves intimate contact of the laminate film and imparts good moisture impermeability.

In the laminate film, in terms of versatility and reactivity, the group having a reactive carbon-carbon double bond is preferably an acryloyl group.

In the laminate film, it is preferable that the barrier film includes a first polymer film and a moisture impermeable layer formed on the first polymer film, and the adhesion-enhancing layer is formed on the moisture impermeable layer side of the barrier film. With the barrier film having the above configuration, sufficient moisture impermeability is easily obtained.

In the laminate film, it is preferable that the moisture impermeable layer includes a layer of an oxide, nitride, or oxynitride having atoms of at least one substance selected from a group consisting of aluminum, titanium, copper, indium, and silicon. With the moisture impermeable layer having the above configuration, both of transparency and moisture impermeability are easily obtained.

In the laminate film, it is preferable that the barrier film further includes a second polymer film disposed on the moisture impermeable layer, and the adhesion-enhancing layer is formed on the second polymer film. With the barrier film having the above configuration, breakage is further reduced during processing, distribution.

The laminate film preferably has a total light transmittance of 80% or more. With the total light transmittance of 80% or more, the laminate film can be favorably used for a light-emitting unit. Further, the laminate film is preferably used for protecting phosphors.

The present invention also provides a laminate including a cured laminate film obtained by curing the adhesion-enhancing layer of the laminate film described above, and a resin film formed on a cured adhesion-enhancing layer side surface of the cured laminate film.

The present invention further provides a wavelength conversion sheet including a wavelength conversion layer, and a pair of protective films respectively formed on both surfaces of the wavelength conversion layer. In the wavelength conversion sheet, at least one of the protective films is a cured laminate film obtained by curing the adhesion-enhancing layer of the laminate film described above. The wavelength conversion sheet of the present invention improves intimate contact with the wavelength conversion layer, and maintains good appearance and light-emitting efficiency after long-term storage at a high temperature.

The present invention further provides a backlight unit including a light-emitting diode light source and the wavelength conversion sheet described above. The backlight unit using the laminate film described above prevents external oxygen or moisture from contacting the wavelength conversion layer, and enables long-term use of a backlight without deterioration of the phosphors.

The present invention further provides an electroluminescent light-emitting unit including an electroluminescent light-emitting layer, and a cured laminate film obtained by curing the adhesion-enhancing layer of the laminate film described above. The electroluminescent light-emitting unit using the laminate film prevents external oxygen or moisture from contacting the electroluminescent light-emitting layer, and enables long-term use of the electroluminescent light-emitting unit without deterioration of the electroluminescent light-emitting layer.

### [Advantageous Effects of the Invention]

The present invention provides a laminate film and a laminate that can improve intimate contact and obtain good moisture impermeability, and provides a wavelength conversion sheet, a backlight unit, and an electroluminescent light-emitting unit, which are all obtained using the laminate film and the laminate.

### [Brief Description of Drawings]

Fig. 1 is a schematic cross-sectional view of a laminate film according to an embodiment of the present invention.
Fig. 2 is a schematic cross-sectional view of a laminate according to an embodiment of the present invention.
Fig. 3 is a schematic cross-sectional view of a wavelength conversion sheet according to a first embodiment of the present invention.
Fig. 4 is a schematic cross-sectional view of a wavelength conversion sheet according to a second embodiment of the present invention.
Fig. 5 is a schematic cross-sectional view of a backlight unit for a liquid crystal display, according to an embodiment of the present invention.
Fig. 6 is a schematic cross-section of an electroluminescent light-emitting unit according to an embodiment of the present invention.

### [Description of Embodiments]

Embodiments of the present invention will hereinafter be described in details. It should be noted that the present invention should not be construed as being limited to the embodiments below.

### (Laminate film 20)

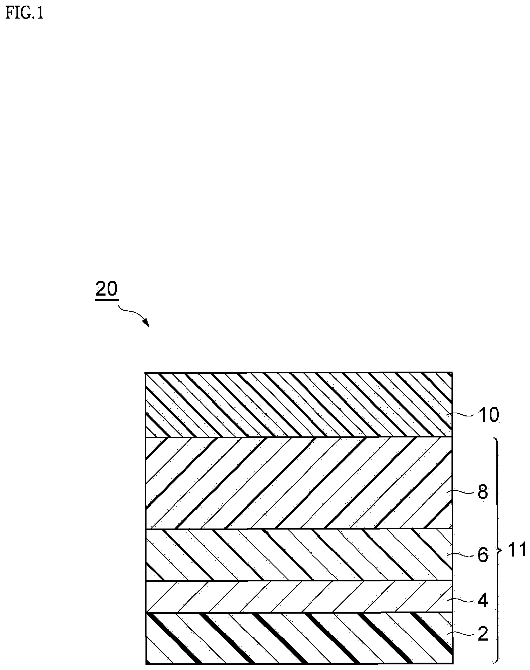

Fig. 1 is a schematic cross-sectional view of a laminate film according to an embodiment of the present invention. A laminate film 20 of the present embodiment includes a first polymer film 2, a moisture impermeable layer 4 formed on the first polymer film 2, a second polymer film 8 formed on the moisture impermeable layer 4, and an adhesion-enhancing layer 10 formed on the second polymer film 8. In Fig. 1, the second polymer film 8 is disposed on the moisture impermeable layer 4 via a tackifier layer or adhesive layer 6.

In Fig. 1, the layers other than the adhesion-enhancing layer 10 can be collectively referred to as a barrier film 11. The barrier film 11 has gas barrier properties. The configuration of the barrier film 11 is not limited to the one shown in Fig. 1. For example, in the laminate film 20, the barrier film 11 may include the first polymer film 2, and the moisture impermeable layer 4 formed on the first polymer film 2. In this case, the adhesion-enhancing layer 10 can be formed on the moisture impermeable layer 4 side of the barrier film 11. With the barrier film 11 being provided with the first polymer film 2 and the moisture impermeable layer 4, sufficient strength and moisture impermeability are more easily obtained. In the laminate film 20, the barrier film 11 may further include the second polymer film 8 disposed on the moisture impermeable layer 4. In this case, the adhesion-enhancing layer 10 can be formed on the second polymer film 8. With the barrier film 11 being provided with the second polymer film 8, breakage during processing, distribution, and the like can be further reduced.

In the laminate film 20 of the present embodiment, the moisture impermeable layer 4 may be formed on the first polymer film 2 via an anchor coat layer (not shown). Moreover, the second polymer film 8 may be disposed on the moisture impermeable layer 4 without the tackifier layer or adhesive layer 6 interposed therebetween. Moreover, the adhesion-enhancing layer 10 may be formed on the second polymer film 8 via an anchor coat layer (not shown).

The laminate film 20 of the present embodiment can be favorably used as a protective film for emitters or phosphors. In terms of favorably using the laminate film 20 as a protective film for emitters or phosphors, the laminate film 20 preferably has a total light transmittance of 80% or more, and more preferably 85% or more.

### (First polymer film 2)

The first polymer film 2 is a layer for preventing the occurrence of breakage during processing, distribution. Examples of the material for the first polymer film 2 include, but are not limited to: polyesters such as polyethylene terephthalate, polybutylene terephthalate, and polyethylene naphthalate; polyamides such as nylon; polyolefins such as polypropylene and cycloolefin; polycarbonates; triacetyl cellulose. The first polymer film 2 is preferably a polyester film, a polyamide film, or a polyolefin film, more preferably a polyester film or a polyamide film, and further preferably a polyethylene terephthalate film. Moreover, the first polymer film 2 is preferably biaxially oriented.

The first polymer film 2 may include, as needed, additives such as an antistatic agent, an ultraviolet absorbing agent, a plasticizer, and a lubricant. Moreover, the first polymer film 2 may have a corona-treated, flame-treated, or plasma-treated surface.

The thickness of the first polymer film 2 is not particularly limited, but is preferably in the range of 3 µm or more to 100 µm or less, and more preferably 5 µm or more to 50 µm or less.

### (Moisture impermeable layer 4)

The moisture impermeable layer 4 serves to prevent entry of moisture into a light-emitting unit. The moisture impermeable layer 4 may be a single-layer or multilayer. The moisture impermeable layer 4 is preferably transparent. In terms of transparency, the moisture impermeable layer 4 is preferably formed by vacuum deposition.

The moisture impermeable layer 4 is formed on the first polymer film 2 via an anchor coat layer, as needed. The anchor coat layer may be a polyester resin with a thickness in the range of 0.01 to 10 µm. The method of forming the moisture impermeable layer 4 is not particularly limited, but in terms of further enhancing moisture impermeability, vacuum deposition is preferable. Examples of vacuum deposition include physical vapor deposition, chemical vapor deposition. Non-limiting examples of physical vapor deposition include vacuum vapor deposition, sputtering, ion plating. Non-limiting examples of chemical vapor deposition (CVD) include thermal CVD, plasma-enhanced CVD, optical CVD.

The method of forming the moisture impermeable layer 4 is preferably vacuum deposition, sputtering, or plasma-enhanced CVD, and more preferably resistance heating vacuum vapor deposition, electron beam heating vacuum deposition, induction heating vacuum deposition, reactive sputtering, dual magnetron sputtering, or plasma-enhanced chemical vapor deposition (PECVD). The method of forming the moisture impermeable layer 4 may be sputtering in terms of moisture impermeability, and may be vacuum deposition in terms of cost, and thus can be selected according to usage.

Examples of the method of generating plasma in sputtering and plasma-enhanced CVD can include methods based on DC (direct current), RF (radio frequency), MF (medium frequency), DC pulse, RF pulse, and DC+RF superimposition.

In the case of sputtering, a negative potential gradient is generated at a target that is a negative electrode, and Ar+ ions, which have received potential energy, impinge on the target. When plasma is generated, but no negative self-bias potential is generated, sputtering cannot be performed. Accordingly, MW (micro wave) plasma, which does not generate self-bias, is not suitable for sputtering. PECVD, however, can use MW plasma because PECVD uses vapor-phase reactions in the plasma to advance the process of chemical reaction and deposition and enable film formation without self-bias.

In the case of vacuum deposition, a metal or oxide film is generally formed, and thus a metal film such as of aluminum, titanium, copper, indium or tin, an oxide film of any of these metals (alumina), or an oxide film of silicon is usually formed. Moreover, a film such as of a nitride may be formed, besides the metal or oxide film. Alternatively, a film that contains a plurality of metals may be formed. The moisture impermeable layer 4 preferably includes a layer of an oxide, nitride, or oxynitride having atoms of at least one substance selected from the group consisting of aluminum, titanium, copper, indium, and silicon, because these substances are superior in both of transparency and moisture impermeability. The moisture impermeable layer 4 more preferably includes a layer of a silicon oxide or an oxynitride, because these substances are much superior in moisture impermeability.

The moisture impermeable layer 4 formed by vacuum deposition preferably has a thickness in the range of 5 nm or more to 100 nm or less. If the moisture impermeable layer 4 formed by vacuum deposition has a thickness of 5 nm or more, moisture barrier properties are likely to be obtained. If the moisture impermeable layer 4 formed by vacuum deposition has a thickness of 100 nm or less, generation of cracks due to cure shrinkage is likely to be minimized, and thus moisture barrier properties are likely to be prevented from being deteriorated due to the cracks. The moisture impermeable layer 4 with a thickness of 1,000 nm or less is preferable in terms of economic aspect, i.e. reducing cost, which is ascribed to reduction in the amount of materials to be used, the time taken for film formation.

The moisture impermeable layer 4 can also be formed in atmospheric air. If the moisture impermeable layer 4 is formed in atmospheric air, an oxide film such as of metal can be formed by using, for example, a coating liquid containing: a compound that contains chlorine such as polyvinylidene chloride; and a compound that contains atoms such as of Si, Ti, Al, and Zr. The moisture impermeable layer 4 may also be formed by combining a layer formed in vacuum and a layer formed in atmospheric air.

Specifically, as the method of applying the coating liquid in forming the moisture impermeable layer 4 in atmospheric air, mention can be made of gravure coating, dip coating, reverse coating, wire bar coating, die coating.

The compound that contains Si atoms may be a silane compound, for example. The oxide film is preferably formed by reaction of a silanol group contained in the silane compound. Such a silane compound includes a compound expressed by Formula (1) below.

R¹ₙ(OR²)₄₋ₙSi (1)

In Formula (1), n is an integer 0 to 3, and R¹ and R² are each a hydrocarbon group, and preferably an alkyl group having a carbon number 1 to 4. Examples of the compound expressed by Formula (1) include tetramethoxy silane, tetraethoxy silane, tetrapropoxy silane, tetrabutoxy silane, methyltrimethoxy silane, methyltriethoxy silane, dimethyldimethoxy silane, and dimethyldiethoxy silane. Polysilazane that contains nitrogen may also be used.

Examples of the compound that contains Ti atoms include a compound expressed by Formula (2) below.

R¹ₙ(OR²)₄₋ₙTi (2)

In Formula (2), n is an integer 0 to 3, and R¹ and R² are each a hydrocarbon group, and preferably an alkyl group having a carbon number 1 to 4. Examples of the compound expressed by Formula (2) include tetramethoxy titanium, tetraethoxy titanium, tetraisopropoxy titanium, tetrabutoxy titanium.

Examples of compounds that contain Al atoms include compounds expressed by Formula (3) below.

R¹ₙ(OR²)₄₋ₙAl (3)

In Formula (3), n is an integer 0 to 3, and R¹ and R² are each a hydrocarbon group, and preferably an alkyl group having a carbon number 1 to 4. Examples of the compound expressed by Formula (3) include tetramethoxy aluminum, tetraethoxy aluminum, tetraisopropoxy aluminum, tetrabutoxy aluminum.

Examples of compounds that contain Zr atoms include compounds expressed by Formula (4) below.

R¹ₙ(OR²)₄₋ₙZr (4)

In Formula (4), n is an integer 0 to 3, and R¹ and R² are each a hydrocarbon group, and preferably an alkyl group having a carbon number 1 to 4. Examples of the compound expressed by Formula (4) include tetramethoxy zirconium, tetraethoxy zirconium, tetraisopropoxy zirconium, tetrabutoxy zirconium, and the like. In Formulas (1) to (4), R¹, R², and n are independent of one another.

If the moisture impermeable layer 4 is formed in atmospheric air, the coating liquid mentioned above is applied, followed by curing. The curing method is not particularly limited, but examples thereof include ultraviolet curing, thermal curing, and the like. In the case of ultraviolet curing, the coating liquid may contain a polymerization initiator, and a compound that has a double bond. As needed, the coating liquid may be heat aged.

If the moisture impermeable layer 4 is formed in atmospheric air, the moisture impermeable layer 4 may be a reaction product of dehydration condensation of inorganic oxide particles such as of magnesium, calcium, zinc, aluminum, silicon, titanium, or zirconium via phosphorus atoms derived from a phosphorus compound. Specifically, a functional group (e.g., hydroxyl group) that is present on a surface of the inorganic oxide, and a portion of the phosphorus compound that can react with the inorganic oxide (e.g., halogen atoms directly bonded to phosphorus atoms, or oxygen atoms directly bonded to phosphorus atoms) cause a condensation reaction for bonding. The reaction product can be obtained, for example, by applying a coating liquid that contains the inorganic oxide and the phosphorus compound to a surface of a base material, followed by heat treating the applied film to advance the reaction of mutually bonding inorganic oxide particles via phosphorus atoms derived from the phosphorus compound. The lower limit temperature of the heat treatment is 110°C, preferably 120°C, more preferably 140°C, and even more preferably 170°C. A low heat treatment temperature makes it difficult to obtain a satisfactory reaction speed and lowers productivity. A preferable upper limit heat treatment temperature depends on the base material, but is 220°C, and is preferably 190°C. The heat treatment can be performed in air, a nitrogen atmosphere, an argon atmosphere.

If the moisture impermeable layer 4 is formed in atmospheric air, the coating liquid mentioned above may further contain a resin, as long as coagulation does not occur in the coating liquid. Specific examples of the resin include acrylic resins, polyester resins, polyvinyl alcohols, polyvinyl pyrrolidone. The coating liquid preferably contains, among these resins, a resin having high compatibility with other materials contained in the coating liquid.

The coating liquid may further contain, as needed, a filler, a leveling agent, an antifoaming agent, an ultraviolet absorbing agent, and an antioxidant, and, separately from these agents, a silane coupling agent, a titanium chelating agent.

The thickness of the moisture impermeable layer 4 formed in atmospheric air is preferably in the range of 50 nm to 1,000 nm, and more preferably 100 nm to 800 nm. If the moisture impermeable layer 4 formed in atmospheric air has a thickness of 50 nm or more, film formation is likely to be easier. If the moisture impermeable layer 4 formed in atmospheric air has a thickness of 1,000 nm or less, fracture or curling is likely to be reduced.

The moisture impermeable layer 4 may also be a multilayer film including a layer formed by vacuum deposition, and a layer formed of a coating liquid. The multilayer film can be ensured to have a structure in which layers formed by vacuum deposition and layers formed of a coating liquid are alternately laminated to further improve barrier properties.

To improve adhesion with the tackifier layer or adhesive layer 6, or improve bending resistance of the moisture impermeable layer 4, a coating layer may be formed on the moisture impermeable layer 4. If the coating layer is formed on the moisture impermeable layer 4 formed by vacuum deposition, the coating layer is preferably formed by using, for example, a homopolymer of acrylic acid or methacrylic acid, such as PAA (polyacrylic acid) and PMAA (polymethacrylic acid), or a copolymer obtained by copolymerizing monomers that contain acrylic acid or methacrylic acid, such as EAA (ethylene acrylic acid copolymer) or EMAA (ethylene methacrylic acid copolymer), in terms of improving intimate contact between the tackifier layer or adhesive layer 6 and the coating layer.

### (Second polymer film 8)

The second polymer film 8 is disposed on the moisture impermeable layer 4 via the tackifier layer or adhesive layer 6 as needed. Non-limiting examples of the second polymer film 8 include: polyesters such as polyethylene terephthalate, polybutylene terephthalate, and polyethylene naphthalate; polyamides such as nylon; polyolefins such as polypropylene and cycloolefin; polycarbonates; triacetyl cellulose. The second polymer film 8 is preferably a polyester film or a polyamide film, and more preferably a polyethylene terephthalate film. The second polymer film 8 is preferably biaxially oriented.

The second polymer film 8 may contain, as needed, additives such as an antistatic agent, an ultraviolet absorbing agent, a plasticizer, and a lubricant. The second polymer film 8 may have a corona-treated, flame-treated, or plasma-treated surface.

The thickness of the second polymer film 8 is not particularly limited, but preferably in the range of 3 µm or more to 100 µm or less, and more preferably 5 µm or more to 50 µm or less.

The tackifier layer or adhesive layer 6 is preferably formed by coating a solution of an tackifier/adhesive onto the moisture impermeable layer 4, and bonding the second polymer film 8 to the coated surface. As the tackifier or the adhesive (tackifier/adhesive), one generally used as a tackifier/adhesive for a polymer film can be used, and thus is appropriately selected in conformity with the surface of the moisture impermeable layer 4. Examples of the tackifier/adhesive include polyester tackifiers/adhesives, acrylic tackifiers/adhesives, rubber tackifiers/adhesives, phenolic tackifiers/adhesives, urethane tackifiers/adhesives.

The method of coating a solvent of the tackifier/adhesive includes gravure coating, dip coating, reverse coating, wire bar coating, die coating.

The tackifier layer or adhesive layer 6 preferably has a thickness in the range of 1 µm or more to 20 µm or less. If the thickness of the tackifier layer or adhesive layer 6 is 1 µm or more, adhesion is likely to be obtained, and if 20 µm or less, a poor-quality surface or cost increase is likely to be reduced. Bonding of the second polymer film 8 to the surface coated with the solution of the tackifier/adhesive is followed by aging. Aging is performed at 20 to 80°C for 1 to 10 days, for example.

The tackifier/adhesive may also contain, as needed, a curing agent, an antistatic agent, a silane coupling agent, an ultraviolet absorbing agent, an antioxidant, a leveling agent, a dispersant.

In the laminate film 20 of the present invention, the barrier film 11 may also be optionally configured as shown in Configurational Examples 1 to 10 described below. With reference to Fig. 1, Configurational Examples 1 to 10 that the laminate film 20 can have will be described.

### Configurational Example 1: first polymer film 2 / moisture impermeable layer 4

The barrier film 11 has a basic configuration made up of at least the first polymer film 2 and the moisture impermeable layer 4.

### Configurational Example 1-a: polymer film / moisture impermeable layer formed by vacuum deposition

The method of forming the moisture impermeable layer 4 is not particularly limited, but, in terms of further enhancing moisture impermeability, the layer is preferably formed by vacuum deposition with which a closely-packed film can be formed.

### Configurational Example 1-b: polymer film / moisture impermeable layer formed in atmospheric air

The moisture impermeable layer 4 can also be formed in atmospheric air. If the moisture impermeable layer 4 is formed in atmospheric air, the coating liquid that contains, for example, a compound that contains chlorine such as polyvinylidene chloride, and a compound that contains atoms such as of Si, Ti, Al, Zr, is used to form an oxide film, thereby providing a moisture impermeable layer.

### Configurational Example 2: first polymer film 2 / anchor coat layer / moisture impermeable layer 4

The moisture impermeable layer 4 may be formed on the first polymer film 2 via an anchor coat layer.

### Configurational Example 3: first polymer film 2 / moisture impermeable layer 4 / sealing layer

A sealing layer (not shown) may further be formed on the moisture impermeable layer 4. By preventing damage to the moisture impermeable layer 4, moisture impermeability is further improved. If the sealing layer is formed on the moisture impermeable layer 4, the sealing layer is preferably formed by use of, for example, a homopolymer of acrylic acid or methacrylic acid, such as PAA (polyacrylic acid) or PMAA (polymethacrylic acid), or a copolymer obtained by copolymerizing monomers that contain acrylic acid or methacrylic acid, such as EAA (ethylene acrylic acid copolymer) or EMAA (ethylene methacrylic acid copolymer).

### Configurational Example 4: first polymer film 2 / moisture impermeable layer formed by vacuum deposition / moisture impermeable layer formed in atmospheric air

The moisture impermeable layer 4 may also be a multilayer film made up of a moisture impermeable layer formed by vacuum deposition, and a moisture impermeable layer formed with a coating liquid in atmospheric air.

### Configurational Example 5: first polymer film 2 / moisture impermeable layer formed by vacuum deposition / moisture impermeable layer formed in atmospheric air / ... / moisture impermeable layer formed by vacuum deposition / moisture impermeable layer formed in atmospheric air

The moisture impermeable layer 4 may be a multilayer film obtained by alternately laminating moisture impermeable layers formed by vacuum deposition, and moisture impermeable layers formed with a coating liquid in atmospheric air. With the moisture impermeable layer 4 having a structure of the aforementioned multilayer film, barrier properties are further improved.

### Configurational Example 6: first polymer film 2 / moisture impermeable layer 4 formed by vacuum deposition / (meth)acrylate resin layer

### Configurational Example 7: first polymer film 2 / (meth)acrylate resin layer / moisture impermeable layer 4 formed by vacuum deposition / (meth)acrylate resin layer

### Configurational Example 8: first polymer film 2 / (meth)acrylate resin layer / moisture impermeable layer formed by vacuum deposition / (meth)acrylate resin layer / ... / moisture impermeable layer formed by vacuum deposition / (meth)acrylate resin layer

Adopting the configuration obtained by laminating a moisture impermeable layer formed by vacuum deposition, with a (meth)acrylate resin layer (Configurational Example 6), or the configuration obtained by sandwiching a moisture impermeable layer formed by vacuum deposition with acrylate resin layers (Configurational Example 7), moisture impermeability of the moisture impermeable layer 4 is improved. In particular, moisture impermeability is further improved by flash depositing or coating a cross-linkable functional (meth)acrylate onto a moisture impermeable layer, and forming cross-links by an electron beam or heat and providing a configuration in which (meth)acrylate resin layers are alternately laminated with moisture impermeable layers (Configurational Example 8).

### Configurational Example 9: first polymer film 2 / moisture impermeable layer 4 / tackifier layer or adhesive layer 6 / second polymer film 8

As another configuration, a solution of a tackifier may be coated onto the moisture impermeable layer 4 so as to bond the second polymer film 8 to the applied film. The second polymer film 8 can be bonded to the moisture impermeable layer 4 via the tackifier layer or adhesive layer 6 to thereby prevent damage to the moisture impermeable layer 4, and further improve moisture impermeability.

### Configurational Example 10: first polymer film 2 / first moisture impermeable layer 4 / tackifier layer or adhesive layer 6 / second moisture impermeable layer / second polymer film 8

A second moisture impermeable layer (not shown) may further be formed on the second polymer film 8, with which moisture impermeability can be further improved. If the second moisture impermeable layer is formed on the second polymer film 8, the second moisture impermeable layer is preferably configured to be disposed on the tackifier layer side.

### (Adhesion-enhancing layer 10)

The adhesion-enhancing layer 10 is formed on the second polymer film 8 (on the barrier film 11). The adhesion-enhancing layer 10 contains a polymer that contains a group having a reactive carbon-carbon double bond and two or more hydroxyl groups, and polyisocyanate. The adhesion-enhancing layer 10 may further contain a monomer that contains a group having a reactive carbon-carbon double bond and a hydroxyl group, described below. The reactive carbon-carbon double bond refers to a radically or cationically polymerizable carbon-carbon double bond. The group having a reactive carbon-carbon double bond is preferably a group having an ethylenically-unsaturated double bond, more preferably a styryl group, a (meth)acryloyl group, for example, and even more preferably an acryloyl group. If the group having a reactive carbon-carbon double bond is an acryloyl group, reactivity is likely to be improved, and better intimate contact is likely to be achieved.

The polymer that contains a group having a reactive carbon-carbon double bond and two or more hydroxyl groups can be obtained by polymerizing monomers that contain a group having a reactive carbon-carbon double bond. The aforementioned monomers may be of one kind, or may be of two or more kinds. When the monomers used for producing a polymer are of one kind, the aforementioned monomers contain a group having a reactive carbon-carbon double bond and a group having a hydroxyl group. When the monomers used for producing the polymer are of two or more kinds, the aforementioned monomers can be a combination of monomers that contain a group having a reactive carbon-carbon double bond and a hydroxyl group, with monomers that contain a group having a reactive carbon-carbon double bond.

The aforementioned monomers that contain a group having a reactive carbon-carbon double bond are preferably monomers that contain a (meth)acryloyl group, or monomers that contain a styryl group, and more preferably monomers that contain a (meth)acryloyl group. Examples of the monomers that contain a (meth)acryloyl group include (meth)acrylic acid, alkyl (meth)acrylate, urethane (meth)acrylate, epoxy (meth)acrylate. The carbon number of an alkyl group of the alkyl (meth)acrylate is 1 to 5, for example. The monomers that contain a group having a reactive carbon-carbon double bond and a hydroxyl group are preferably monomers that contain a (meth)acryloyl group and a hydroxyl group, or monomers that contain a styryl group and a hydroxyl group, and more preferably monomers that contain a (meth)acryloyl group and a hydroxyl group. The monomers that contain a (meth)acryloyl group and a hydroxyl group include (meth)acrylic acid, hydroxyalkyl (meth)acrylate, pentaerythritol triacrylate. The carbon number of an alkyl group in the hydroxyalkyl (meth)acrylate is 1 to 5, for example.

The aforementioned polymer may be obtained by polymerizing monomers alone, or may be obtained by polymerizing an acrylic prepolymer obtained in advance with a monomer. The acrylic prepolymer is a polymer obtained by polymerizing acrylic monomers such as acrylic acid, methacrylic acid, and glycidyl (meth)acrylate, i.e. obtained by polymerizing acrylic monomers of at least one kind that contain a hydroxyl group. Examples of the acrylic monomers that contain a hydroxyl group include hydroxyethyl (meth)acrylate, hydroxypropyl (meth)acrylate, N-methylolacrylamide, and the like. The acrylic prepolymer preferably has a weight-average molecular weight in the range of 5,000 to 10,000.

When the aforementioned polymer is obtained by ultraviolet irradiation, monomers are polymerized in the presence of a photopolymerization initiator. Examples of such a photopolymerization initiator include acetophenones, benzoins, benzophenones, phosphine oxides, ketals, anthraquinones, thioxanthones.

Monomers may also be polymerized, as needed, in the presence of a photosensitizer, such as n-butylamine, triethylamine or poly-n-butylphosphine, an antistatic agent, a silane coupling agent, an ultraviolet absorbing agent, an antioxidant, a leveling agent, a dispersant.

As a raw material of the polyisocyanate, mention can be made of tolylene diisocyanate, diphenylmethane diisocyanate, hexamethylene diisocyanate, isophorone diisocyanate, xylylene diisocyanate, or the like. The polyisocyanate may also be a prepolymer obtained by permitting isocyanates to react with each other, or a prepolymer obtained by reaction of isocyanate with alcohol. The content of the polyisocyanate in the adhesion-enhancing layer 10 is preferably in the range of 1 to 100 parts by mass, and more preferably 3 to 60 parts by mass, relative to 100 parts by mass of the polymer that contains a group having a reactive carbon-carbon double bond and two or more hydroxyl groups.

The adhesion-enhancing layer 10 is obtained, for example, by applying an adhesive containing a polymer that contains a group having a reactive carbon-carbon double bond and two or more hydroxyl groups, and polyisocyanate onto the second polymer film 8 (on the barrier film 11), and drying the applied film. The aforementioned adhesive preferably contains a polymer that contains a group having a reactive carbon-carbon double bond and two or more hydroxyl groups, polyisocyanate, and a solvent that dissolves the aforementioned polymer and the polyisocyanate. The solvent that can be used includes, for example, methyl ethyl ketone, methyl isobutyl ketone, cyclohexanone, ethyl acetate, butyl acetate, methanol, ethanol, isopropyl alcohol, butanol.

When the aforementioned adhesive contains a solvent, the adhesive preferably has a solid content in the range of 0.5 to 30 mass%, and more preferably 1 to 10 mass%, with respect to the total amount of the adhesive.

Examples of the method of coating the adhesive onto the second polymer film 8 (on the barrier film 11) include gravure coating, dip coating, reverse coating, wire bar coating, die coating. The applied film is dried by heating at 50 to 250°C for 1 second to 20 minutes, for example.

The thickness of the adhesion-enhancing layer 10 obtained as described above is in the range of 0.01 µm or more to 1 µm or less. The thickness of the adhesion-enhancing layer 10 is preferably 0.02 µm or more, more preferably 0.05 µm or more, and even more preferably 0.1 µm or more. When the adhesion-enhancing layer 10 has a thickness of 0.01 µm or more, intimate contact is likely to be improved. The thickness of the adhesion-enhancing layer 10 is preferably 0.8 µm or less, and more preferably 0.5 µm or less. When the adhesion-enhancing layer 10 has a thickness of 1 µm or less, the adhesion-enhancing layer 10 is unlikely to be influenced by the stress from outside, and intimate contact is likely to be improved.

An adhesion-enhancing layer containing the polymer that contains a group having a reactive carbon-carbon double bond and two or more hydroxyl groups, and polyisocyanate may further be formed on a surface of the first polymer film 2 opposite from the surface where the moisture impermeable layer 4 is formed.

### (Laminate 30)

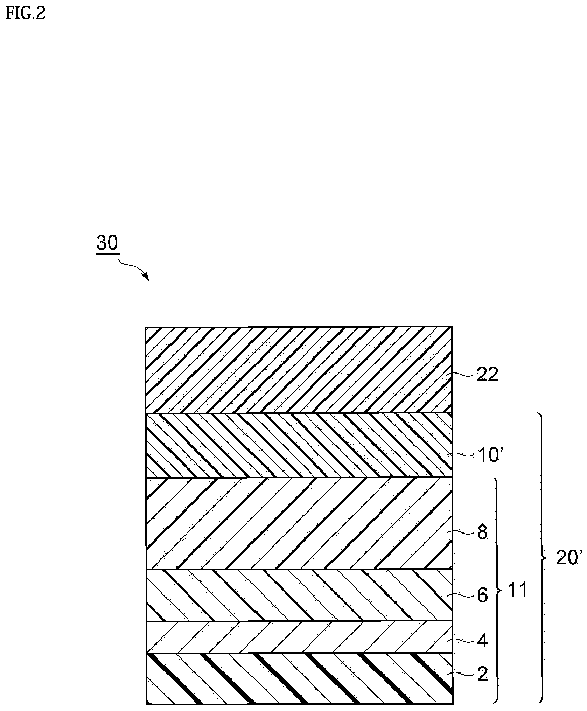

Fig. 2 is a schematic cross-sectional view of a laminate according to an embodiment of the present invention. A laminate 30 according to the present embodiment includes, in one aspect, the first polymer film 2, the moisture impermeable layer 4 formed on the first polymer film 2, the second polymer film 8 formed on the moisture impermeable layer 4, a cured adhesive layer 10' formed on the second polymer film 8, and a resin film 22 formed on the cured adhesive layer 10'. The cured adhesive layer 10' is obtained by curing the adhesion-enhancing layer 10 of the laminate film 20 by light irradiation and/or heating, for example, of the adhesion-enhancing layer 10. A laminate film which includes the cured adhesion-enhancing layer (cured adhesive layer) 10' obtained by curing the adhesion-enhancing layer 10 of the laminate film 20 may be referred to as a cured laminate film. The laminate 30 of the present embodiment includes, in another aspect, the cured laminate film 20', and the resin film 22 formed on a cured adhesion-enhancing layer (cured adhesive layer) 10' side surface of the cured laminate film 20'. In Fig. 2, the layers other than the cured adhesive layer 10' and the resin film 22 can collectively be referred to as the barrier film 11. The laminate 30 of the present embodiment only needs to include the barrier film 11, the cured adhesive layer 10' formed on the barrier film 11, and the resin film 22 formed on the cured adhesive layer 10'. Similarly to the laminate film 20, the configuration of the barrier film 11 is not limited to the configuration shown in Fig. 2.

The laminate 30 of the present embodiment may also be obtained, for example, by bonding the resin film 22 to a surface of the adhesion-enhancing layer 10 of the laminate film 20, followed by light irradiation and/or heating. Due to light irradiation or heating, hydroxyl groups in the polymer react with isocyanate groups in the polyisocyanate in the adhesion-enhancing layer 10, thereby forming a urethane bond, so that the adhesion-enhancing layer 10 turns into the cured adhesive layer 10'. The laminate 30 according to the present embodiment may also be obtained, for example, by forming a resin layer on a surface of the adhesion-enhancing layer 10 of the laminate film 20, followed by light irradiation and/or heating. In this case, due to light irradiation or heating, the reaction mentioned above occurs in the adhesion-enhancing layer, while the resin layer is cured to serve as the resin film 22. It should be noted that the resin layer is obtained, for example, by coating and drying a liquid resin composition which is curable by light irradiation or heating (curable liquid resin composition).

Resins that can be used for the resin film 22 are not particularly limited, but include, for example, thermoplastic resins, and cured products such as of thermoplastic resins, thermosetting resins, electron beam curable resins, ultraviolet curable resins. Therefore, when the resin film 22 is obtained by curing a resin layer, the curable liquid resin composition may contain at least one resin selected from the group consisting of thermosetting resins, electron beam curable resins, and ultraviolet curable resins. The thermoplastic resins include a polyester resin, an acrylic resin, an acrylic urethane resin, a polyester acrylate resin, a polyurethane acrylate resin, a urethane resin, a polycarbonate resin. The thermosetting resins include an epoxy resin, a melamine resin, a phenolic resin. The resin used for the resin film 22 is preferably an acrylic resin or a cured epoxy resin, in terms of exhibiting good light resistance or optical properties.

The resin film 22 (or the curable liquid resin composition) may include fine particles, for example. The resin film 22 may have a surface with microscopic asperities caused by the fine particles being exposed. When the laminate 30 including the resin film 22, whose surface is provided with the asperities, is used for a light-emitting unit, generation of Newton's rings is likely to be prevented.

The fine particles contained in the resin film 22 are not particularly limited, but can include, for example, inorganic fine particles of silica, clay, talc, calcium carbonate, calcium sulfate, barium sulfate, titanium oxide, alumina, and organic fine particles of a styrene resin, a urethane resin, a silicone resin, an acrylic resin. The fine particles can be used singly or in combination of two or more.

The resin film 22 is preferably an optical film. When the resin film 22 is an optical film, optical functions can be imparted to the light-emitting unit. The optical functions are not particularly limited, but include functions such as of interference fringe (moire) prevention, antireflection, and dispersion. In terms of imparting optical functions to the resin film 22, the resin used for the resin film 22 preferably has good optical transparency.

Light irradiation can be conducted, for example, using a metal halide lamp, a high-pressure mercury lamp. Heating can be conducted at 50 to 250°C for 1 second to 20 minutes, for example.

### (Wavelength conversion sheet 100)

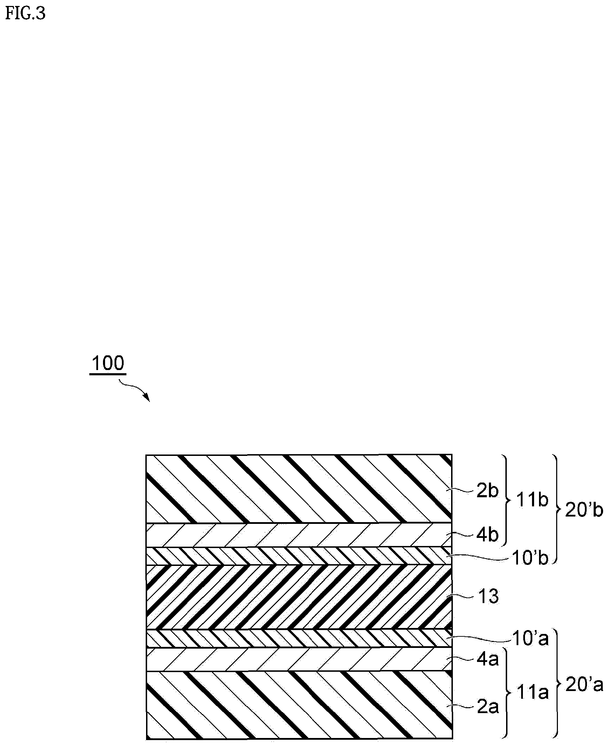

Using the laminate film 20 and the laminate 30, a wavelength conversion sheet can be provided. Fig. 3 is a schematic cross-sectional view of a wavelength conversion sheet according to a first embodiment of the present invention. In Fig. 3, a wavelength conversion sheet 100 includes a wavelength conversion layer 13, and a pair of cured laminate films 20'a and 20'b, as protective films, respectively formed on opposite surfaces of the wavelength conversion layer 13. The first cured laminate film 20'a includes a first polymer film 2a, a moisture impermeable layer 4a formed on the first polymer film 2a, and a cured adhesive layer 10'a formed on the moisture impermeable layer 4a. The second cured laminate film 20'b includes a first polymer film 2b, a moisture impermeable layer 4b formed on the first polymer film 2b, and a cured adhesive layer 10'b formed on the moisture impermeable layer 4b. The first cured laminate film 20'a is formed on a surface of the wavelength conversion layer 13 such that the first cured adhesive layer 10'a faces the wavelength conversion layer 13. The second cured laminate film 20'b is formed on the other surface of the wavelength conversion layer 13 such that the second cured adhesive layer 10'b faces the wavelength conversion layer 13. The wavelength conversion sheet 100 may include the wavelength conversion layer 13 and a pair of protective films respectively formed on opposite surfaces of the wavelength conversion layer 13, with only one of the protective films being the cured laminate film 20'.

In Fig. 3, the layers of the first cured laminate film 20'a other than the cured adhesive layer 10'a can collectively be referred to as a first barrier film 11a, and the layers of the second cured laminate film 20'b other than the cured adhesive layer 10'b can collectively be referred to as a second barrier film 11b. In Fig. 3, the first barrier film 11a includes the first polymer film 2a, and the moisture impermeable layer 4a formed on the first polymer film 2a, while the second barrier film 11b includes the first polymer film 2b, and the moisture impermeable layer 4b formed on the first polymer film 2b. The first cured adhesive layer 10'a is formed on the moisture impermeable layer 4a of the first barrier film 11a, while the second cured adhesive layer 10'b is formed on the moisture impermeable layer 4b of the second barrier film 11b. The details of the configuration of the cured laminate film 20' are as described above.

The wavelength conversion sheet 100 of the present embodiment can be obtained, for example, by preparing two laminate films 20, forming a wavelength conversion layer 13 on an adhesion-enhancing layer 10 in one of the laminate films 20, bonding the other of the laminate films 20 such that the adhesion-enhancing layer 10 and the wavelength conversion layer 13 face each other, and curing the adhesion-enhancing layers 10.

The wavelength conversion layer 13 is an emitter layer that converts energy from outside into light energy to emit light by excitation light being incident thereon. The wavelength conversion layer 13 is obtained by sandwiching and hermetically sealing a phosphor layer by a pair of laminate films 20, with the respective first polymer films 2 being located inside, and sealing, as needed, a space between the phosphor layer and the laminate films 20 with a sealing resin. The wavelength conversion layer 13 has a thickness in the range of 10 to 500 µm, for example.

The phosphor layer contains a resin and phosphors. As the resin, a photocurable resin or a thermosetting resin can be used, for example. The phosphors may have cores serving as light-emitting portions and shells covering the respective cores and serving as protective films. The cores can be served such as by cadmium selenide (CdSe), for example, and the shells can be served such as by zinc sulfide (ZnS), for example. Surface defects of CdSe particles are covered with ZnS having a large band gap to thereby improve quantum efficiency. The phosphors may have cores doubly covered with respective first shells and second shells. In this case, CsSe can be used for the cores, zinc selenide (ZnSe) can be used for the first shells, and ZnS can be used for the second shells. Two or more types of phosphors are combined and used. Alternatively, a phosphor layer containing only one type of phosphors may be laminated with another phosphor layer containing only one type of phosphors. As the two types of phosphors, those having the same excitation wavelength are selected. The excitation wavelength is selected based on the wavelength of the light radiated from a light-emitting diode light source. The two types of phosphors have fluorescent colors different from each other. The fluorescent colors are red and green. The wavelengths of fluorescences, and the wavelength of the light radiated from the light-emitting diode light source are selected based on spectral characteristics of the color filter. The peak wavelength of fluorescence is 610 nm for red, and 550 nm for green, for example. The phosphors are preferably quantum dots. The phosphors have a mean particle size in the range of 1 nm to 20 nm, for example.

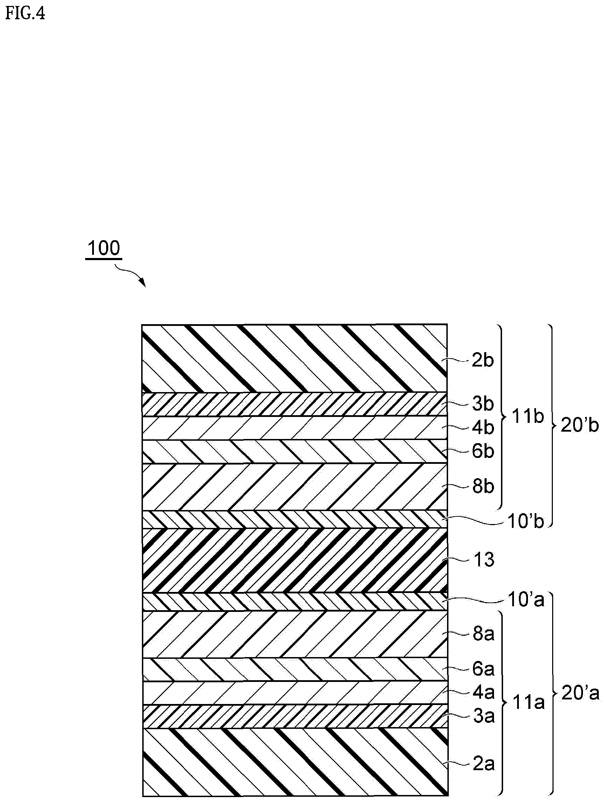

Fig. 4 is a schematic cross-sectional view of a wavelength conversion sheet according to a second embodiment of the present invention. A wavelength conversion sheet 100 of the present embodiment differs from the wavelength conversion sheet of the first embodiment in that the barrier film 11a of the first cured laminate film 20'a includes a first polymer film 2a, a moisture impermeable layer 4a formed on the first polymer film 2a via an anchor coat layer 3a, and a second polymer film 8a formed on the moisture impermeable layer 4a via a tackifier layer or adhesive layer 6a, and that the barrier film 11b of the second cured laminate film 20'b includes a first polymer film 2b, a moisture impermeable layer 4b formed on the first polymer film 2b via an anchor coat layer 3b, and a second polymer film 8b formed on the moisture impermeable layer 4b via an tackifier layer or adhesive layer 6b. The first cured adhesive layer 10'a is formed on the second polymer film 8a of the barrier film 11a, and the second cured adhesive layer 10'b is formed on the second polymer film 8b of the barrier film 11b. Details of the configuration of each of the cured laminate film 20' and the wavelength conversion layer 13 are as described above.

In the wavelength conversion sheet 100 of the present embodiment, the cured laminate film 20'a only needs to include the barrier film 11a and the cured adhesive layer 10'a formed on the barrier film 11a, and cured laminate film 20'b only needs to include the barrier film 11b and the cured adhesive layer 10'b formed on the barrier film 11b. Similarly to the laminate film 20, the configurations of the barrier films 11a and 11b are not limited to the ones shown in Figs. 3 and 4.

When the wavelength conversion sheet 100 is prepared using the laminate 30, the wavelength conversion sheet 100 can be obtained, for example, by preparing two laminates 30, forming a wavelength conversion layer 13 on the first polymer film 2 in one of the laminates 30, and bonding the other of the laminates 30 thereto such that the first polymer film 2 and the wavelength conversion layer 13 face each other. The wavelength conversion layer 13 is obtained by sandwiching and hermetically sealing a phosphor layer by the pair of laminates 30, with the first polymer films 2 being located inside, and sealing, as needed, a space between the phosphor layer and each of the laminates 30 with a sealing resin.

The sealing resin that can be used includes, for example, a thermoplastic resin, a thermosetting resin, an ultraviolet curable-type resin, or the like. The thermoplastic resin that can be used includes, for example: cellulose derivatives such as acetyl cellulose, nitro cellulose, acetyl butyl cellulose, ethyl cellulose, and methyl cellulose; vinyl resins such as vinyl acetate and copolymers thereof, vinyl chloride and copolymers thereof, and vinylidene chloride and copolymers thereof; acetal resins such as polyvinyl formal and polyvinyl butyral; acrylic resins such as an acrylic resin and copolymers thereof, a methacrylic resin and copolymers thereof; a polystyrene resin; a polyamide resin; a linear polyester resin; a fluorine resin; a polycarbonate resin; or the like. As the thermosetting resin, mention can be made of a phenolic resin, a urea melamine resin, a polyester resin, a silicone resin, or the like. As the photocurable resin, mention can be made of a photopolymerizable prepolymer such as epoxy acrylate, urethane acrylate, and polyester acrylate. These photopolymerizable prepolymers may be used as main components, and a monofunctional or polyfunctional monomer may be used as a diluent.

### (Backlight unit 50)

Using the laminate film 20 and the laminate 30, a light-emitting unit can be provided. An example of the light-emitting unit obtained by using the laminate film 20 and the laminate 30 will be described below.

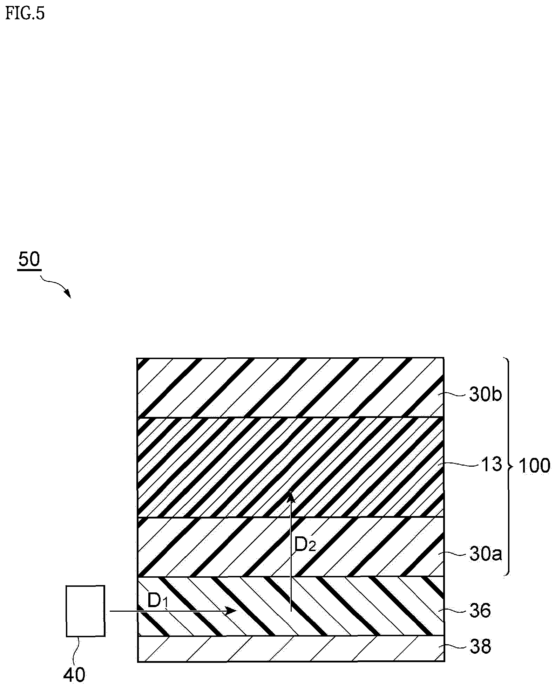

Fig. 5 is a schematic cross-sectional view of a backlight unit for a liquid crystal display, according to an embodiment of the present invention. A backlight unit 50 of the present embodiment includes a light-emitting diode light source 40, and a wavelength conversion sheet 100. On a surface of the wavelength conversion sheet 100, a light guiding layer 36 and a reflecting layer 38 are further disposed in this order, and the light-emitting diode light source 40 is disposed on a lateral side of the light guiding layer 36 (in a planar direction of the light guiding layer 36). Such a backlight unit 50 can prevent external oxygen or moisture from contacting the phosphor layer, and barrier film 11a, and cured laminate film 20'b only needs to include the barrier film 11b and the cured adhesive layer 10'b formed on the barrier film 11b. Similarly to the laminate film 20, the configurations of the barrier films 11a and 11b are not limited to the ones shown in Figs. 3 and 4.

When the wavelength conversion sheet 100 is produced using the laminate 30, the wavelength conversion sheet 100 can be obtained, for example, by preparing two laminates 30, forming a wavelength conversion layer 13 on the first polymer film 2 in one of the laminates 30, and bonding the other of the laminates 30 thereto such that the first polymer film 2 and the wavelength conversion layer 13 face each other. The wavelength conversion layer 13 is obtained by sandwiching and hermetically sealing a phosphor layer by the pair of laminates 30, with the first polymer films 2 being located inside, and sealing, as needed, a space between the phosphor layer and each of the laminates 30 with a sealing resin.

### (Backlight unit 50)

Using the laminate film 20 and the laminate 30, a light-emitting unit can be provided. An example of the light-emitting unit obtained by using the laminate film 20 and the laminate 30 will be described below.

Fig. 5 is a schematic cross-sectional view of a backlight unit for a liquid crystal display, according to an embodiment of the present invention. A backlight unit 50 of the present embodiment includes a light-emitting diode light source 40, and a wavelength conversion sheet 100. On a surface of the wavelength conversion sheet 100, a light guiding layer 36 and a reflecting layer 38 are further disposed in this order, and the light-emitting diode light source 40 is disposed on a lateral side of the light guiding layer 36 (in a planar direction of the light guiding layer 36). Such a backlight unit 50 can prevent external oxygen or moisture from contacting the phosphor layer, and enables long-term use of the backlight without deterioration of the phosphor layer.

The light guiding layer 36 and the reflecting layer 38 efficiently reflect and guide the light radiated from the light-emitting diode light source 40. Known materials are used for these layers. As the light guiding layer 36, for example, a film such as of acryl, polycarbonate, or cycloolefin, is used.

The light-emitting diode light source 40 includes a plurality of light-emitting diodes that emit blue light. These light-emitting diodes may also be violet light-emitting diodes, or light-emitting diodes of a shorter wavelength. The light radiated from the light-emitting diode light source 40 enters the light guiding layer 36 (in a D1 direction), and then, being reflected and refracted, for example, enters the wavelength conversion layer 13 (in a D2 direction). While passing through the wavelength conversion layer 13, the light is mixed with yellow light of a wide wavelength range generated in the wavelength conversion layer 13 and becomes white light.

### (Electroluminescent light-emitting unit 70)

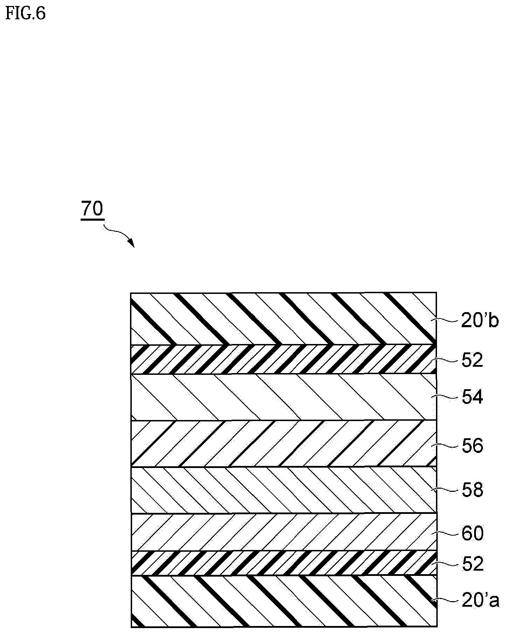

Fig. 6 is a schematic cross-sectional view of an electroluminescent light-emitting unit according to an embodiment of the present invention. An electroluminescent light-emitting unit 70 of the present embodiment includes an electroluminescent light-emitting layer 56, and a cured laminate film 20'. The cured laminate film means the same film as described above. The electroluminescent light-emitting layer 56 converts the energy from outside into light energy to emit light with the application of an electric field thereto. The electroluminescent light-emitting unit 70 is obtained, for example, by preparing an electrode element including a transparent electrode layer 54, an electroluminescent light-emitting layer 56 provided on the transparent electrode layer 54, a dielectric layer 58 provided on the electroluminescent light-emitting layer 56, and a back surface electrode layer 60 provided on the dielectric layer 58, and sandwiching and hermetically sealing the electrode element between a pair of cured laminate films 20' each having a sealant layer 52 formed on a surface thereof. The backlight unit that uses the laminate films can prevent external oxygen or moisture from contacting the phosphor layer, and enables long-term use of the electroluminescent light-emitting unit without deterioration of the electroluminescent light-emitting layer. The electrode and the electroluminescent emitter layer may be intervened therebetween, as needed, with a hole injection layer, a hole transport layer, an electron transport layer, an electron injection layer.

The electrode layer, the electroluminescent light-emitting layer, and the dielectric layer can be formed, for example, by deposition, sputtering. The sealant layer that can be used includes an acid-modified, polyolefin resin obtained by graft-modifying a polyolefin resin with an acid, the resins mentioned above as sealing resins.

### [Examples]

### (Preparation of laminate film and laminate)

### [Example 1]

Using bar coating, a polyester resin solution was coated onto a corona discharge treated surface of a biaxially-oriented polyethylene terephthalate film (first polymer film 2, trade name: P60, thickness: 12 µm, manufactured by TORAY INDUSTRIES, INC.), followed by drying and curing at 80°C for 1 minute, thereby forming an anchor coat layer with a thickness of 100 nm.

Using an electron beam heating vacuum deposition device, a silicon oxide material (SiO, manufactured by Canon Optron Inc.) was evaporated by electron beam heating under a pressure of 1.5 × 10⁻² Pa, thereby forming an SiOₓ film (moisture impermeable layer 4) with a thickness of 80 nm on the anchor coat layer. The deposition was conducted by applying an accelerating voltage of 40 kV and an emission current of 0.2 A.

An adhesive (trade name: TAKELAC A525, manufactured by Mitsui Chemicals, Inc.) was coated onto the moisture impermeable layer 4. Then, the moisture impermeable layer 4 was bonded, via the adhesive, to a corona discharge treated surface of a biaxially-oriented polyethylene terephthalate film (second polymer film 8, trade name: FE2001, thickness: 25 µm, manufactured by FUTAMURA CHEMICAL CO., LTD.), followed by aging at 50°C for 2 days. The adhesive layer 6 after bonding had a thickness of 5 µm.

A mixed solution was prepared by mixing 70 parts by mass of acrylic resin (weight-average molecular weight: 30,000) obtained by polymerizing 35 parts by mass of acrylic acid, 35 parts by mass of hydroxyethyl acrylate, and 30 parts by mass of n-butyl acrylate, with 30 parts by mass of an isocyanurate form of hexamethylene diisocyanate (trade name: Desmodur N3300, manufactured by Sumika Bayer Urethane Co., Ltd.), and the mixed solution was coated onto the second polymer film 8. The coated liquid was dried to form an adhesion-enhancing layer 10 with a thickness of 0.2 µm, thereby obtaining a laminate film 20.

An epoxy sheet (the optical film 22, trade name: XNR5516Z, manufactured by Nagase ChemteX Corporation) was bonded to the adhesion-enhancing layer 10 of the laminate film 20 thus obtained. The laminate film bonded with the epoxy sheet was irradiated with UV (ultraviolet rays) at an exposure of 6J/cm², followed by baking at 80°C for 60 minutes, thereby obtaining a laminate 30.

### [Example 2]

Using bar coating, a polyester resin solution was coated onto a biaxially-oriented polyethylene terephthalate film (first polymer film 2, trade name: A4100, thickness: 50 µm, manufactured by TOYOBO CO., LTD.), followed by drying and curing at 80°C for 1 minute, thereby forming an anchor coat layer with a thickness of 100 nm.

Using a resistance heating vacuum deposition device, an aluminum material (trade name: 4N, manufactured by Kojundo Chemical Lab. Co., Ltd.) was evaporated by heating under a pressure of 3.0 × 10⁻² Pa to form an AlOₓ film with a thickness of 10 nm on the anchor coat layer. The deposition was conducted by applying an accelerating voltage of 50 kV and an emission current of 0.5 A.

A mixed liquid obtained by mixing a hydrolysate of tetraethoxy silane and polyvinyl alcohol at a mass ratio of 1/1 was coated onto the AlOₓ film by bar coating, followed by drying and curing at 120°C for 1 minute, thereby forming an SiOₓ film with a thickness of 400 nm. The multilayer film including the AlOₓ film and the SiOₓ film and formed on the anchor coat layer in this way was used as a moisture impermeable layer 4.

An adhesive (trade name: TAKELAC A525, manufactured by Mitsui Chemicals, Inc.) was coated onto the moisture impermeable layer 4. Then, the moisture impermeable layer 4 was bonded, via the adhesive, to a corona discharge treated surface of a biaxially-oriented polyethylene terephthalate film (second polymer film 8, trade name: FE2001, thickness: 25 µm, manufactured by FUTAMURA CHEMICAL CO., LTD.), followed by aging at 50°C for 2 days. The adhesive layer 6 after bonding had a thickness of 5 µm.

A mixed solution was prepared by mixing 70 parts by mass of acrylic resin (weight-average molecular weight: 30,000) obtained by polymerizing 35 parts by mass of acrylic acid, 35 parts by mass of hydroxyethyl acrylate, and 30 parts by mass of n-butyl acrylate, with 30 parts by mass of an isocyanurate form of hexamethylene diisocyanate (trade name: Desmodur N3300, manufactured by Sumika Bayer Urethane Co., Ltd.), and the mixed solution was coated onto the second polymer film 8. The coated liquid was dried to form an adhesion-enhancing layer 10 with a thickness of 0.2 µm, thereby obtaining a laminate film 20.

An epoxy sheet (optical film 22, trade name: XNR5516Z, manufactured by Nagase ChemteX Corporation) was bonded to the adhesion-enhancing layer 10 of the laminate film 20 thus obtained. The laminate film bonded with the epoxy sheet was irradiated with UV (ultraviolet rays) at an exposure of 6J/cm², followed by baking at 80°C for 60 minutes, thereby obtaining a laminate 30.

### [Comparative Example 1]

Using bar coating, a polyester resin solution was coated onto a corona discharge treated surface of a biaxially-oriented polyethylene terephthalate film (first polymer film, trade name: P60, thickness: 12 µm, manufactured by TORAY INDUSTRIES, INC.), followed by drying and curing at 80°C for 1 minute, thereby forming an anchor coat layer with a thickness of 100 nm.

Using an electron beam heating vacuum deposition device, a silicon oxide material (SiO, manufactured by Canon Optron Inc.) was evaporated by electron beam heating under a pressure of 1.5 × 10⁻² Pa to form an SiOₓ film (moisture impermeable layer) with a thickness of 80 nm on the anchor coat layer. The deposition was conducted by applying an accelerating voltage of 40 kV and an emission current of 0.2 A.

An adhesive (trade name: TAKELAC A525, manufactured by Mitsui Chemicals, Inc.) was coated onto the moisture impermeable layer. Then, the moisture impermeable layer was bonded, via the adhesive, to a corona discharge treated surface of a biaxially-oriented polyethylene terephthalate film (second polymer film, trade name: FE2001, thickness: 25 µm, manufactured by FUTAMURA CHEMICAL CO., LTD.), followed by aging at 50°C for 2 days. The adhesive layer after bonding had a thickness of 5 µm.

An acrylic resin (weight-average molecular weight: 30,000) was obtained by polymerizing 35 parts by mass of acrylic acid, 35 parts by mass of hydroxyethyl acrylate, and 30 parts by mass of n-butyl acrylate to prepare a solution of the acrylic resin. The solution was coated onto the second polymer film, followed by drying to form an adhesion-enhancing layer with a thickness of 0.2 µm, thereby obtaining a laminate film.

An epoxy sheet (optical film, trade name: XNR5516Z, manufactured by Nagase ChemteX Corporation) was bonded to the adhesion-enhancing layer of the laminate film thus obtained. The laminate film bonded with the epoxy sheet was irradiated with UV (ultraviolet rays) at an exposure of 6J/cm², followed by baking at 80°C for 60 minutes, thereby obtaining a laminate.

### [Comparative Example 2]

Using bar coating, a polyester resin solution was coated onto a biaxially-oriented polyethylene terephthalate film (first polymer film, trade name: A4100, thickness: 50 µm, manufactured by TOYOBO CO., LTD.), followed by drying and curing at 80°C for 1 minute, thereby forming an anchor coat layer with a thickness of 100 nm.

Using a resistance heating vacuum deposition device, an aluminum material (trade name: 4N, manufactured by Kojundo Chemical Lab. Co., Ltd.) was evaporated by heating under a pressure of 3.0 × 10⁻² Pa, with oxygen being introduced, thereby forming an AlOₓ film with a thickness of 10 nm on the anchor coat layer. The deposition was conducted by applying an accelerating voltage of 50 kV and an emission current of 0.5 A.

A mixed liquid obtained by mixing a hydrolysate of tetraethoxy silane with polyvinyl alcohol at a mass ratio of 1/1 was coated onto the AlOₓ film by bar coating, followed by drying and curing at 120°C for 1 minute, thereby forming an SiOₓ film with a thickness of 400 nm. The multilayer film including the AlOₓ film and the SiOₓ film and formed on the anchor coat layer in this way was used as a moisture impermeable layer.

An adhesive (trade name: TAKELAC A525, manufactured by Mitsui Chemicals, Inc.) was coated onto the moisture impermeable layer. Then, the moisture impermeable layer was bonded, via the adhesive, to a corona discharge treated surface of a biaxially-oriented polyethylene terephthalate film (second polymer film, trade name: FE2001, thickness: 25 µm, manufactured by FUTAMURA CHEMICAL CO., LTD.), followed by aging at 50°C for 2 days. The adhesive layer after bonding had a thickness of 5 µm.

A mixed solution was prepared so as to contain 70 parts by mass of polyester urethane resin (trade name: UR1350, manufactured by TOYOBO CO., LTD.) and 30 parts by mass of an isocyanurate form of hexamethylene diisocyanate, and the solution was coated onto the second polymer film. The coated liquid was dried to form an adhesion-enhancing layer with a thickness of 0.2 µm, thereby obtaining a laminate film.

An epoxy sheet (optical film, trade name: XNR5516Z, manufactured by Nagase ChemteX Corporation) was bonded to the adhesion-enhancing layer of the laminate film thus obtained. The laminate film bonded with the epoxy sheet was irradiated with UV (ultraviolet rays) at an exposure of 6J/cm², followed by baking at 80°C for 60 minutes, thereby obtaining a laminate.

### Inventive Example 3]

An adhesive (trade name: TAKELAC A525, manufactured by Mitsui Chemicals, Inc.) was coated onto a corona discharge treated surface of a biaxially-oriented polyethylene terephthalate film (first polymer film, trade name: P60, thickness: 12 µm, manufactured by TORAY INDUSTRIES, INC.). Then, the biaxially-oriented polyethylene terephthalate film was bonded, via the adhesive, to a corona discharge treated surface of a biaxially-oriented polyethylene terephthalate film (second polymer film, trade name: FE2001, thickness: 25 µm, manufactured by FUTAMURA CHEMICAL CO., LTD.), followed by aging at 50°C for 2 days. The adhesive layer after bonding had a thickness of 5 µm.

A mixed solution was prepared by mixing 70 parts by mass of acrylic resin (weight-average molecular weight: 30,000) obtained by polymerizing 35 parts by mass of acrylic acid, 35 parts by mass of hydroxyethyl acrylate, and 30 parts by mass of n-butyl acrylate, with 30 parts by mass of an isocyanurate form of hexamethylene diisocyanate (trade name: Desmodur N3300, manufactured by Sumika Bayer Urethane Co., Ltd.), and the mixed solution was coated onto the second polymer film. The coated liquid was dried to form an adhesion-enhancing layer with a thickness of 0.2 µm, thereby obtaining a laminate film.

An epoxy sheet (optical film, trade name: XNR5516Z, manufactured by Nagase ChemteX Corporation) was bonded to the adhesion-enhancing layer of the laminate film thus obtained. The laminate film bonded with the epoxy sheet was irradiated with UV (ultraviolet rays) at an exposure of 6J/cm², followed by baking at 80°C for 60 minutes, thereby obtaining a laminate.

### [Comparative Example 4]

Using bar coating, a polyester resin solution was coated onto a biaxially-oriented polyethylene terephthalate film (first polymer film, trade name: A4100, thickness: 50 µm, manufactured by TOYOBO CO., LTD.), followed by drying and curing at 80°C for 1 minute, thereby forming an anchor coat layer with a thickness of 100 nm.

Using a resistance heating vacuum deposition device, an aluminum material (trade name: 4N, manufactured by Kojundo Chemical Lab. Co., Ltd.) was evaporated by heating under a pressure of 3.0 × 10⁻² Pa to form an AlOₓ film with a thickness of 10 nm on the anchor coat layer. The deposition was conducted by applying an accelerating voltage of 50 kV and an emission current of 0.5 A.

A mixed liquid obtained by mixing a hydrolysate of tetraethoxy silane with polyvinyl alcohol at a mass ratio of 1/1 was coated onto the AlOₓ film by bar coating, followed by drying and curing at 120°C for 1 minute, thereby forming an SiOₓ film with a thickness of 400 nm. The multilayer film including the AlOₓ film and the SiOₓ film and formed on the anchor coat layer in this way was used as a moisture impermeable layer.

An adhesive (trade name: TAKELAC A525, manufactured by Mitsui Chemicals, Inc.) was coated onto the moisture impermeable layer. Then, the moisture impermeable layer was bonded, via the adhesive, to a corona discharge treated surface of a biaxially-oriented polyethylene terephthalate film (trade name: FE2001, thickness: 25 µm, manufactured by FUTAMURA CHEMICAL CO., LTD.), followed by aging at 50°C for 2 days. The adhesive layer after bonding had a thickness of 5 µm.

A mixed solution was prepared by mixing 70 parts by mass of acrylic resin (weight-average molecular weight: 30,000) obtained by polymerizing 35 parts by mass of acrylic acid, 35 parts by mass of hydroxyethyl acrylate, and 30 parts by mass of n-butyl acrylate, with 30 parts by mass of an isocyanurate form of hexamethylene diisocyanate (trade name: Desmodur N3300, manufactured by Sumika Bayer Urethane Co., Ltd.), and the mixed solution was coated onto the second polymer film. The coated liquid was dried to form an adhesion-enhancing layer with a thickness of 2 µm, thereby obtaining a laminate film.

An epoxy sheet (optical film, trade name: XNR5516Z, manufactured by Nagase ChemteX Corporation) was bonded to the adhesion-enhancing layer of the laminate film thus obtained. The laminate film bonded with the epoxy sheet was irradiated with UV (ultraviolet rays) at an exposure of 6J/cm², followed by baking at 80°C for 60 minutes, thereby obtaining a laminate.

### (Evaluation method)

### (Moisture impermeability)

The moisture impermeability of the laminate films obtained in Examples 1 and 2 and Comparative Examples 1 to 4 were evaluated by measuring moisture permeability using a method in conformance with the infrared sensor method of JIS K 7129. For the measurement of moisture permeability, a moisture permeability measurement device (trade name: Permatran, manufactured by MOCON Inc.) was used. The temperature of a permeation cell was set to 40°C, the relative humidity of a high-humidity chamber was set to 90% RH, and the relative humidity of a low-humidity chamber was set to 0% RH. Table 1 shows measurements of moisture permeability.

### (Total light transmittance)

The total light transmittance was measured for each of the laminate films obtained in Examples 1 and 2 and Comparative Examples 1 to 4 using a hazemeter device (trade name: NDH2000, manufactured by NIPPON DENSHOKU INDUSTRIES Co., LTD). Table 1 shows measurements of total light transmittance.

### (Intimate contact between adhesion-enhancing layer and second polymer film)

According to an adhesion evaluation test method which is in conformance with the cross-cut method of JIS K 5600-5-6 (ISO2409), the adhesion-enhancing layers of the laminate films obtained in Examples 1 and 2 and Comparative Examples 1 to 4 were each cut into a 1 mm-square lattice pattern, and a cellophane tape was attached to the adhesion-enhancing layer. After the cellophane tapes were peeled off from the respective adhesion-enhancing layers, intimate contact was evaluated according to the criteria below. Table 1 shows evaluations of intimate contact between the adhesion-enhancing layer and the second polymer film.
A: The adhesion-enhancing layer did not peel off from the second polymer film (Classes 0 to 2 of JIS K 5600-5-6).
B: The adhesion-enhancing layer peeled off from the second polymer film (Classes 3 to 5 of JIS K 5600-5-6).

### (Intimate contact between optical film and adhesion-enhancing layer)

The laminates obtained in Examples 1 and 2 and Comparative Examples 1 to 4 were each cut into a strip of 1 cm width, and the epoxy sheet (optical film) side of each strip of the laminate was fixed onto a glass plate. Using a TENSILON universal testing machine (manufactured by A&D Company, Limited), the fixed laminate film strips of the laminates were each peeled off from the epoxy sheet in a direction perpendicular to the glass plate at a speed of 300 mm/minute, to measure the strength required for peeling. The intimate contact between the optical film and the adhesion-enhancing layer was evaluated according to the criteria below. Table 1 shows evaluations of intimate contact between the optical film and the adhesion-enhancing layer.
A: The peel strength was 2N/cm or more.
B: The peel strength was less than 2N/cm.

Comparative example 3 disclosed in Table 1 is inventive example 1 according to the invention disclosed in the application.

**[Table 1]**

| | Polymer having two or more hydroxyl groups | | Polyisocyanate | Moisture impermeable layer | Thickness of adhesion-enhancing layer | Moisture impermeability (g/m² • day) | Total light transmittance | Intimate contact between adhesion-enhancing layer and second polymer film | Intimate contact between optical film and adhesion-en hancing layer |
|---|---|---|---|---|---|---|---|---|---|
| | | Reactive carbon-carbon double bond | | | | | | | |
| Ex. 1 | Acrylic resin | Present | Present | Present | 0.2 µm | 0.5 | 87% | A | A |
| Ex. 2 | Acrylic resin | Present | Present | Present | 0.2 µm | 0.8 | 86% | A | A |
| Comp. Ex. 1 | Acrylic resin | Present | Absent | Present | 0.2 µm | 0.5 | 87% | B | B |
| Comp Ex. 2 | Polyester urethane resin | Absent | Present | Present | 0.2 µm | 0.8 | 86% | A | B |
| Comp Ex. 3 | Acrylic resin | Present | Present | Absent | 0.2 µm | > 10 | 87% | A | A |
| Comp Ex. 4 | Acrylic resin | Present | Present | Present | 2 µm | 0.8 | 86% | A | B |

As shown in Table 1, in the laminate films and the laminates of Examples 1 and 2, good moisture impermeability and good intimate contact were achieved. In contrast, in the laminate film and the laminate of Comparative Example 1 not using polyisocyanate to form the adhesion-enhancing layer, intimate contact was not sufficiently achieved between the adhesion-enhancing layer and the second polymer film, and between the optical film and the adhesion-enhancing layer. In the laminate of Comparative Example 2 using a polyester urethane resin having no reactive carbon-carbon double bond to form the adhesion-enhancing layer, intimate contact was not sufficiently achieved between the optical film and the adhesion-enhancing layer. The laminate film of Inventive Example 3 not including the moisture impermeable layer could not achieve sufficient moisture impermeability. In the laminate of Comparative Example 4 including the adhesion-enhancing layer with a thickness exceeding 1 µm, intimate contact was not sufficiently achieved between the optical film and the adhesion-enhancing layer.

### (Fabrication of wavelength conversion sheet)

### [Example 3]

To prepare the wavelength conversion sheet shown in Fig. 4, a biaxially-oriented polyethylene terephthalate film (trade name: P60, thickness: 12 µm, manufactured by TORAY INDUSTRIES, INC.) was corona discharge treated for use as a first polymer film 2a. Using bar coating, a polyester resin solution was coated onto a surface of the first polymer film 2a, followed by drying and curing at 80 °C for 1 minute, thereby forming an anchor coat layer 3a with a thickness of 100 nm.

Using an electron beam heating vacuum deposition device, a silicon oxide material (manufactured by Canon Optron Inc.) was evaporated by electron beam heating under a pressure of 1.5 × 10⁻² Pa to form an SiOₓ film with a thickness of 40 nm on the anchor coat layer 3a. The deposition was conducted by applying an accelerating voltage of 40 kV and an emission current of 0.2 A.

A mixed liquid prepared by mixing a hydrolysate of tetraethoxy silane with polyvinyl alcohol at a mass ratio of 1/1 was coated onto the SiOₓ film by bar coating, followed by drying and curing at 120°C for 1 minute, thereby forming an SiOₓ film with a thickness of 400 nm. Further, through a similar procedure, an SiOₓ film with a thickness of 40 nm was formed by vacuum deposition, and then an SiOₓ film with a thickness of 400 nm was formed by coating. The multilayer film thus formed on the anchor coat layer and included two alternations of vacuum deposited SiOₓ films and coated SiOₓ films was used as the moisture impermeable layer 4a.

An adhesive (trade name: TAKELAC A525, manufactured by Mitsui Chemicals, Inc.) was coated onto the moisture impermeable layer 4a to form the tackifier layer 6a. The moisture impermeable layer 4a was bonded, via the adhesive, to a corona discharge treated surface of a biaxially-oriented polyethylene terephthalate film (second polymer film 8a, trade name: FE2001, thickness: 25 µm, manufactured by FUTAMURA CHEMICAL CO., LTD.), followed by aging at 50°C for 2 days, thereby obtaining the first barrier film 11a. The adhesive layer 6a after bonding had a thickness of 5 µm.

A mixed solution was prepared by mixing 70 parts by mass of acrylic resin (weight-average molecular weight: 30,000) obtained by polymerizing 35 parts by mass of acrylic acid, 35 parts by mass of hydroxyethyl acrylate, and 30 parts by mass of n-butyl acrylate, with 30 parts by mass of an isocyanurate form of hexamethylene diisocyanate (trade name: Desmodur N3300, manufactured by Sumika Bayer Urethane Co., Ltd.), and the mixed solution was coated onto a surface of the second polymer film 8a of the first barrier film 11a. The coated liquid was dried to form a first adhesion-enhancing layer 10a with a thickness of 0.2 µm. In this way, a first laminate film 20a was formed, with the first adhesion-enhancing layer 10a being formed on the first barrier film 11a.

With a method similar to that of the first barrier film 11a, a second barrier film 11b was prepared in which a first polymer film 2b, an anchor coat layer 3b, a moisture impermeable layer 4b, an adhesive layer 6b, and a second polymer film 8b were laminated in this order. Moreover, a second adhesion-enhancing layer 10b with a thickness of 0.2 µm was formed on a surface of the second polymer film 8b of the second barrier film 11b by a method similar to that of the first adhesion-enhancing layer 10a. In this way, a second laminate film 20b was prepared, with the second adhesion-enhancing layer 10b being formed on the second barrier film 11b.

A material obtained as follows was dropped onto the first adhesion-enhancing layer 10a on the first barrier film 11a. Specifically, the material was obtained by dispersing quantum dot emitters, having cores of cadmium selenide (CdSe) and shells of zinc sulfide (ZnS), into a thermosetting epoxy resin. Then, the second adhesion-enhancing layer 10b on the second barrier film 11b was brought into contact with the dropped material. Using a laminator, the first and second barrier films 11a and 11b were laminated with each other via the dropped material, such that the dropped material became a uniform film.

The resultant laminate was aged at room temperature for 24 hours to thereby cure the epoxy resin and form a wavelength conversion layer 13 between the first and second barrier films 11a and 11b, thereby providing a wavelength conversion sheet 100. In this case, the wavelength conversion layer 13 had a thickness of 100 µm.

### [Comparative Example 5]

A wavelength conversion sheet was prepared similarly to Example 3, except that the wavelength conversion layer was formed between the second polymer film of the first barrier film and the second polymer film of the second barrier film, without providing the first and second adhesion-enhancing layers.

### (Evaluation method)

### (Intimate contact with emitter layer)

The wavelength conversion sheets obtained in Example 3 and Comparative Example 5 were each cut into a strip of 1 cm width, and a first barrier film side of each strip of the wavelength conversion sheet was fixed onto a glass plate. Using a TENSILON universal testing machine (manufactured by A&D Company, Limited), the second barrier film of each fixed strip of wavelength conversion sheet was peeled off from the wavelength conversion layer, i.e. an emitter layer, in a direction perpendicular to the glass plate at a speed of 300 mm/minute, to measure the strength required for peeling. The intimate contact between the second barrier film and the emitter layer was evaluated according to the criteria below.
A: The peel strength was 1N/cm or more.
B: The peel strength was less than 1N/cm.

### (Long-term reliable appearance)

The wavelength conversion sheets obtained in Example 3 and Comparative Example 5 were placed in an oven at 85°C for 1,000 hours. Using each of the 1,000-hour lapsed wavelength conversion sheets, the backlight unit shown in Fig. 5 was prepared as a backlight unit for evaluation of long-term reliable appearance. As a light source in the backlight unit, a blue light-emitting diode was used. The light from the backlight unit was visually observed to check the presence or absence of an appearance defect.

### (Long-term reliable light-emitting efficiency)

The wavelength conversion sheets obtained in Example 3 and Comparative Example 5 were each used for preparing the backlight unit shown in Fig. 5, as a backlight unit for evaluating long-term reliable light-emitting efficiency. As a light source in the backlight unit, a blue light-emitting diode was used. Using a luminance meter (manufactured by Konica Minolta, Inc., trade name: LS-100), luminance of the blue light-emitting diode when emitting light (i.e., initial luminance A) was measured for the prepared backlight units. Afterwards, the wavelength conversion sheets were taken out of the backlight unit, placed in an oven at 85°C, and stored for 300 hours. Afterwards, the 300-hour stored wavelength conversion sheets were each used for preparing the backlight unit shown in Fig. 5, and similarly to the initial luminance A, luminance B after storage was measured. The ratio between the initial luminance A and the post-storage luminance B (B/A) was calculated. When the ratio (B/A) was 90% or more, sufficient long-term reliable light-emitting efficiency was determined to have been obtained.

Table 2 shows evaluations of intimate contact between the adhesion-enhancing layer and the emitter layer, long-term reliable appearance, and long-term reliable light-emitting efficiency.

**[Table 2]**

| | Polymer having two or more hydroxyl groups | | Polyisocyanate | Moisture impermeable layer | Thickness of adhesion-enhancing layer | Intimate contact between adhesion-enhancing layer and emitter Layer | Long-term reliable appearance | Long-term reliable light-emitting efficiency |
|---|---|---|---|---|---|---|---|---|
| | | Reactive carbon-carbon double bond | | | | | | |
| Ex. 3 | Acrylic resin | Present | Present | Present | 0.2 µm | A | Not observed | 92% |
| Compo. Ex. 5 | Absent | Absent | Absent | Present | 0.2 µm | B | Observed (Peel-off) | 30% |

As shown in Table 2, in the wavelength conversion sheet of Example 3, good intimate contact was achieved, and thus the backlight unit prepared with the wavelength conversion sheet mentioned above achieved good long-term reliability. In contrast to this, in the wavelength conversion sheet of Comparative Example 5, sufficient intimate contact could not be achieved, and thus the backlight unit prepared with the wavelength conversion sheet mentioned above caused peeling of the first and second barrier films from the wavelength conversion layer during the long-term reliability test. Therefore, the quantum dot emitters became inactive, and the blue light from the light source was recognized in the backlight unit prepared with the stored wavelength conversion sheet. This means that the blue light from the light source was not converted by the wavelength conversion layer (i.e., did not become white light). Accordingly, it can be determined that light emission from the wavelength conversion layer was significantly decreased. The difference is due to the presence/absence of the adhesion-enhancing layer.

### [Reference Signs List]

2, 2a, 2b: First polymer film, 3a, 3b: Anchor coat layer, 4, 4a, 4b: Moisture impermeable layer, 6, 6a, 6b: Tackifier layer or adhesive layer, 8, 8a, 8b: Second polymer film, 10, 10a, 10b: Adhesion-enhancing layer, 10', 10'a, 10'b: Cured adhesive layer, 11, 11a, 11b: Barrier film, 13: Wavelength conversion layer, 20: Laminate film, 20', 20'a, 20'b: Cured laminate film, 22: Resin film, 30: Laminate, 36: Light guiding layer, 38: Reflecting layer, 40: Light-emitting diode light source, 50: Backlight unit, 52: Sealant layer, 54: Transparent electrode layer, 56: Electroluminescent light-emitting layer, 58: Dielectric layer, 60: Back surface electrode layer, 70: Electroluminescent light-emitting unit.

## Claims

1. A laminate film (20) comprising a gas barrier film (11; 11a; 11b) and an adhesion-enhancing layer (10; 10a; 10b) formed on the gas barrier film (11; 11a; 11b), wherein:
the adhesion-enhancing layer (10; 10a; 10b) contains a polymer that contains a group having a reactive carbon-carbon double bond and two or more hydroxyl groups, and polyisocyanate; and
the adhesion-enhancing layer (10; 10a; 10b) has a thickness in a range of 0.01 µm or more to 1 µm or less.

2. The laminate film (20) according to claim 1, wherein the group having a reactive carbon-carbon double bond is an acryloyl group.

3. The laminate film (20) according to claim 1 or 2, wherein the gas barrier film (11; 11a; 11b) includes a first polymer film (2; 2a; 2b) and a moisture impermeable layer (4; 4a; 4b) formed on the first polymer film (2; 2a; 2b), and the adhesion-enhancing layer (10; 10a; 10b) is formed on the moisture impermeable layer (4; 4a; 4b) side of the gas barrier film (11; 11a; 11b).

4. The laminate film (20) according to claim 3, wherein the moisture impermeable layer (4; 4a; 4b) includes a layer of an oxide, nitride, or oxynitride having atoms of at least one substance selected from a group consisting of aluminum, titanium, copper, indium, and silicon.

5. The laminate film (20) according to claim 3 or 4, wherein the gas barrier film (11; 11a; 11b) further includes a second polymer film (8; 8a; 8b) disposed on the moisture impermeable layer (4; 4a; 4b), and the adhesion-enhancing layer (10; 10a; 10b) is formed on the second polymer film (8; 8a; 8b).

6. The laminate film (20) according to any one of claims 1 to 5, wherein the laminate film (20) has a total light transmittance of 80% or more, which is measured by using a hazemeter device.

7. Use of the laminate film (20) according to any one of claims 1 to 6 for protecting phosphors.

8. A laminate (30) comprising a cured laminate film (20'; 20'a; 20'b) obtained by curing the adhesion-enhancing layer (10; 10a; 10b) of the laminate film (20) recited in any one of claims 1 to 7, and a resin film (22) formed on a cured adhesion-enhancing layer (10'; 10'a; 10'b) side surface of the cured laminate film (20'; 20'a; 20'b).

9. A wavelength conversion sheet comprising a wavelength conversion layer (13), and a pair of protective films respectively formed on both surfaces of the wavelength conversion layer (13), wherein at least one of the protective films is a cured laminate film (20'; 20'a; 20'b) obtained by curing the adhesion-enhancing layer (10; 10a; 10b) of the laminate film (20) recited in any one of claims 1 to 7.

10. A backlight unit (50) comprising a light-emitting diode light source (40), and the wavelength conversion sheet recited in claim 9.

11. An electroluminescent light-emitting unit (70) comprising an electroluminescent light-emitting layer (56), and a cured laminate film (20'; 20'a; 20'b) obtained by curing the adhesion-enhancing layer (10; 10a; 10b) of the laminate film (20) recited in any one of claims 1 to 6.

## Patentansprüche

1. Laminatfolie (20), umfassend eine Gasbarrierefolie (11; 11a; 11b) und eine auf der Gasbarrierefolie (11; 11a; 11b) ausgebildete haftungsverstärkende Schicht (10; 10a; 10b), wobei:
die haftungsverstärkende Schicht (10; 10a; 10b) ein Polymer, das eine Gruppe mit einer reaktiven Kohlenstoff-Kohlenstoff-Doppelbindung und zwei oder mehr Hydroxylgruppen enthält, und Polyisocyanat enthält; und
die haftungsverstärkende Schicht (10; 10a; 10b) eine Dicke in einem Bereich von 0,01 µm oder mehr bis 1 µm oder weniger aufweist.

2. Laminatfolie (20) nach Anspruch 1, wobei die Gruppe mit einer reaktiven Kohlenstoff-Kohlenstoff-Doppelbindung eine Acryloylgruppe ist.

3. Laminatfolie (20) nach Anspruch 1 oder 2, wobei die Gasbarrierefolie (11; 11a; 11b) eine erste Polymerfolie (2; 2a; 2b) und eine feuchtigkeitsundurchlässige Schicht (4; 4a; 4b) umfasst, die auf der ersten Polymerfolie (2; 2a; 2b) gebildet ist, und die haftungsverstärkende Schicht (10; 10a; 10b) auf der Seite der feuchtigkeitsundurchlässigen Schicht (4; 4a; 4b) der Gasbarrierefolie (11; 11a; 11b) gebildet ist.

4. Laminatfolie (20) nach Anspruch 3, wobei die feuchtigkeitsundurchlässige Schicht (4; 4a; 4b) eine Schicht eines Oxids, Nitrids oder Oxinitrids mit Atomen mindestens einer Substanz enthält, die aus einer Gruppe ausgewählt ist, die aus Aluminium, Titan, Kupfer, Indium und Silicium besteht.

5. Laminatfolie (20) nach Anspruch 3 oder 4, wobei die Gasbarrierefolie (11; 11a; 11b) ferner eine zweite Polymerfolie (8; 8a; 8b) enthält, die auf der feuchtigkeitsundurchlässigen Schicht (4; 4a; 4b) angeordnet ist, und die haftungsverstärkende Schicht (10; 10a; 10b) auf der zweiten Polymerfolie (8; 8a; 8b) ausgebildet ist.

6. Laminatfolie (20) nach einem der Ansprüche 1 bis 5, wobei die Laminatfolie (20) eine Gesamtlichtdurchlässigkeit von 80% oder mehr aufweist, die unter Verwendung einer Hazemeter-Vorrichtung gemessen wird.

7. Verwendung der Laminatfolie (20) nach einem der Ansprüche 1 bis 6 zum Schutz von Leuchtstoffen.

8. Laminat (30), umfassend eine gehärtete Laminatfolie (20'; 20'a; 20'b), die durch Härten der haftungsverstärkenden Schicht (10; 10a; 10b) der Laminatfolie (20) nach einem der Ansprüche 1 bis 7 erhalten wird, und eine Harzfolie (22), die auf einer Seitenfläche der gehärteten haftungsverstärkenden Schicht (10'; 10'a; 10'b) der gehärteten Laminatfolie (20'; 20'a; 20'b) gebildet ist.

9. Wellenlängenumwandlungsblatt, umfassend eine Wellenlängenumwandlungsschicht (13) und ein Paar Schutzfolien, die jeweils auf beiden Oberflächen der Wellenlängenumwandlungsschicht (13) gebildet sind, wobei mindestens eine der Schutzfolien eine gehärtete Laminatfolie (20'; 20'a; 20'b) ist, die durch Härten der haftungsverstärkenden Schicht (10; 10a; 10b) der Laminatfolie (20) nach einem der Ansprüche 1 bis 7 erhalten wird.

10. Hintergrundbeleuchtungseinheit (50)', umfassend eine Leuchtdioden-Lichtquelle (40) und das Wellenlängenumwandlungsblatt nach Anspruch 9.

11. Elektrolumineszenz-Leuchteinheit (70), umfassend eine Elektrolumineszenz-Leuchtschicht (56) und eine gehärtete Laminatfolie (20'; 20'a; 20'b), erhalten durch Härten der haftungsverstärkenden Schicht (10; 10a; 10b) der Laminatfolie (20) nach einem der Ansprüche 1 bis 6.

## Revendications

1. Film stratifié (20) comprenant un film de barrière aux gaz (11 ; 11a ; 11b) et une couche amplifiant l'adhérence (10 ; 10a ; 10b) formée sur le film de barrière aux gaz (11 ; 11a ; 11b), dans lequel :
la couche amplifiant l'adhérence (10 ; 10a ; 10b) contient un polymère qui contient un groupe ayant une double liaison carbone-carbone réactive et deux ou plus de deux groupes hydroxyle, et un polyisocyanate ; et
la couche amplifiant l'adhérence (10 ; 10a ; 10b) a une épaisseur située dans la plage allant de 0,01 µm ou plus à 1 µm ou moins.

2. Film stratifié (20) selon la revendication 1, dans lequel le groupe ayant une double liaison carbone-carbone réactive est un groupe acryloyle.

3. Film stratifié (20) selon la revendication 1 ou 2, dans lequel le film de barrière aux gaz (11 ; 11a ; 11b) comprend un premier film polymère (2 ; 2a ; 2b) et une couche imperméable à l'humidité (4 ; 4a ; 4b) formée sur le premier film polymère (2 ; 2a ; 2b), et la couche amplifiant l'adhérence (10 ; 10a ; 10b) est formée sur le côté couche imperméable à l'humidité (4 ; 4a ; 4b) du film de barrière aux gaz (11 ; 11a ; 11b).

4. Film stratifié (20) selon la revendication 3, dans lequel la couche imperméable à l'humidité (4 ; 4a ; 4b) comprend une couche d'un oxyde, nitrure ou oxynitrure ayant des atomes d'au moins une substance choisie dans le groupe constitué par l'aluminium, le titane, le cuivre, l'indium, et le silicium.

5. Film stratifié (20) selon la revendication 3 ou 4, dans lequel la couche de barrière aux gaz (11 ; 11a ; 11b) comprend en outre un deuxième film polymère (8 ; 8a ; 8b) disposé sur la couche imperméable à l'humidité (4 ; 4a ; 4b), et la couche amplifiant l'adhérence (10 ; 10a ; 10b) est formée sur le deuxième film polymère (8 ; 8a ; 8b).

6. Film stratifié (20) selon l'une quelconque des revendications 1 à 5, dans lequel le film stratifié (20) a un coefficient de transmission lumineuse total de 80 % ou plus, lequel est mesuré par utilisation d'un dispositif de mesure de voile.

7. Utilisation du film stratifié (20) selon l'une quelconque des revendications 1 à 6 pour la protection de luminophores.

8. Stratifié (30) comprenant un film stratifié durci (20' ; 20'a ; 20'b) obtenu par durcissement de la couche amplifiant l'adhérence (10 ; 10a ; 10b) du film stratifié (20) défini dans l'une quelconque des revendications 1 à 7, et un film de résine (22) formé sur une surface côté couche amplifiant l'adhérence durcie (10' ; 10'a ; 10'b) du film stratifié durci (20' ; 20'a ; 20'b).

9. Feuille de conversion de longueur d'onde comprenant une couche de conversion de longueur d'onde (13), et une paire de films protecteurs respectivement formés sur les deux surfaces de la couche de conversion de longueur d'onde (13), dans laquelle au moins l'un des films protecteurs est un film stratifié durci (20' ; 20'a ; 20'b) obtenu par durcissement de la couche amplifiant l'adhérence (10 ; 10a ; 10b) du film stratifié (20) défini dans l'une quelconque des revendications 1 à 7.

10. Unité de rétroéclairage (50) comprenant une source de lumière à diode luminescente (40) et la feuille de conversion de longueur d'onde définie dans la revendication 9.

11. Unité électroluminescente (70) comprenant une couche électroluminescente (56) et un film stratifié durci (20' ; 20'a ; 20'b) obtenu par durcissement de la couche amplifiant l'adhérence (10 ; 10a ; 10b) du film stratifié (20) défini dans l'une quelconque des revendications 1 à 6.
